# EUROPEAN PATENT APPLICATION

(11) **EP 4 564 426 A1**
(43) Date of publication of application: **04.06.2025**
(21) Application number: 24196997.1
(22) Date of filing: 28.08.2024
(51) Int. Cl.: H01L 23/528

(54) **MULTI-STACK SEMICONDUCTOR DEVICE**

(30) Priority: 28.11.2023 KR 20230168233
(71) Applicant: Samsung Electronics Co., Ltd., Gyeonggi-do, 16677 (KR)
(72) Inventor: PARK, Jisoo, 16677 Suwon-si, Gyeonggi-do (KR); LEE, Junghan, 16677 Suwon-si, Gyeonggi-do (KR); KIM, Byungsung, 16677 Suwon-si, Gyeonggi-do (KR); CHUN, Kwanyoung, 16677 Suwon-si, Gyeonggi-do (KR)
(74) Representative: Kuhnen & Wacker Patent- und Rechtsanwaltsbüro PartG mbB

(57) **Abstract**

A multi-stack semiconductor device may include a back-side power rail (bPWR) extending in a first horizontal direction (X), a first field effect transistor, FET, (1FET) at a level over the back-side power rail (bPWR), a second FET (2FET) over the first FET (1FET), a power rail (PWR) over the second FET (2FET) and extending in the first horizontal direction (X), a back-side source/drain via rail (bVAR) arranged between the back-side power rail (bPWR) and the first FET (1FET) to electrically connect the back-side power rail (bPWR) to the first FET (1FET), and a source/drain via rail (VAR) between the power rail (PWR) and the second FET (2FET) to electrically connect the power rail (PWR) to the second FET (2FET). The back-side source/drain via rail (bVAR) and the source/drain via rail (VAR) may extend in the first horizontal direction (X). The back-side source/drain via rail (bVAR) may at least partially overlap the back-side power rail (bPWR) in a vertical direction (Z). The source/drain via rail (VAR) may at least partially overlap the power rail (PWR) in the vertical direction (Z).

## Description

### BACKGROUND

Inventive concepts relate to a multi-stack semiconductor device, and more particularly, to a multi-stack semiconductor device stacked in a vertical direction.

Recently, down-scaling of semiconductor devices have rapidly progressed. Also, because semiconductor devices require not only high operation speed but also operation accuracy, the structure of a transistor included in a semiconductor device has been optimized. Particularly, as semiconductor devices become more highly integrated, a semiconductor device is designed to include three-dimensional transistors with a multi-gate structure. For example, a three-dimensional transistor may be implemented such that a gate surrounds an active fin formed over a substrate.

### SUMMARY

Inventive concepts provide a multi-stack semiconductor device with electrical resistance relatively reduced by increasing the contact area with respect to a power rail.

However, aspects of inventive concepts are not limited to the objects mentioned above, and other aspects may be clearly understood by those of ordinary skill in the art from the following description.

According to an embodiment of inventive concepts, a multi-stack semiconductor device may include a back-side power rail extending in a first horizontal direction; a first field effect transistor (FET) at a level over the back-side power rail; a second FET over the first FET; a power rail over the second FET and extending in the first horizontal direction; a back-side source/drain via rail between the back-side power rail and the first FET, the back-side source/drain via rail electrically connecting the back-side power rail to the first FET; and a source/drain via rail between the power rail and the second FET, the source/drain via rail electrically connecting the power rail to the second FET. The back-side source/drain via rail and the source/drain via rail may extend in the first horizontal direction. The back-side source/drain via rail may at least partially overlaps the back-side power rail in a vertical direction. The source/drain via rail may at least partially overlap the power rail in the vertical direction.

According to an embodiment of inventive concepts, a multi-stack semiconductor device may include a first back-side power rail and a second back-side power rail extending in a first horizontal direction; a back-side signal rail between the first back-side power rail and the second back-side power rail, the back-side signal rail being spaced apart from the first back-side power rail in a second horizontal direction, the second horizontal direction intersecting the first horizontal direction, and the back-side signal rail extending in the first horizontal direction; a back-side source/drain via rail connected to the first back-side power rail; a first field effect transistor (FET) at a level over the back-side source/drain via rail; and a second FET over the first FET. The first back-side power rail may be configured to supply first power, and the second back-side power rail may be configured to supply second power different from the first power

According to an embodiment of inventive concepts, a multi-stack semiconductor device may include a first back-side power rail and a second back-side power rail extending in a first horizontal direction; a back-side source/drain via rail over the first back-side power rail and extending in the first horizontal direction; a first field effect transistor (FET) at a level over the back-side source/drain via rail; a second FET over the first FET; a source/drain via rail over the second FET and extending in the first horizontal direction; and a first power rail and a second power rail over the source/drain via rail and extending in the first horizontal direction. The first FET may include a first channel, a first gate line covering the first channel and extending in a second horizontal direction intersecting the first horizontal direction, and a first source/drain region on both sides of the first channel in the first horizontal direction. The second FET may include a second channel, a second gate line covering the second channel and extending in the second horizontal direction, and a second source/drain region on both sides of the second channel in the first horizontal direction. The back-side source/drain via rail may overlap the first back-side power rail in a vertical direction. The source/drain via rail may overlap the first power rail in the vertical direction. The first back-side power rail and the first power rail may be configured to supply first power. The second back-side power rail and the second power rail may be configured to supply second power different from the first power.

### BRIEF DESCRIPTION OF THE DRAWINGS

Embodiments will be more clearly understood from the following detailed description taken in conjunction with the accompanying drawings in which:
FIG. 1 is a conceptual diagram for describing a logic cell of a semiconductor device as a comparative example;
FIG. 2 is a conceptual diagram for describing a logic cell of a semiconductor device according to embodiments;
FIG. 3A is a front-side plan view of a multi-stack semiconductor device 10 according to an embodiment;
FIG. 3B is an enlarged view of region "UC" in FIG. 3A;
FIG. 4A is a back-side plan view of a multi-stack semiconductor device 10 according to an embodiment;
FIG. 4B is an enlarged view of region "UC" in FIG. 4A;
FIG. 5A is a diagram illustrating a partial configuration of a cross-section taken along line A1-A1' of FIGS. 3A and 4A;
FIG. 5B is a diagram illustrating a partial configuration of a cross-section taken along line B1-B1' of FIGS. 3A and 4A;
FIG. 5C is a diagram illustrating a partial configuration of a cross-section taken along line B2-B2' of FIGS. 3A and 4A;
FIG. 6 is a schematic diagram briefly illustrating a multi-stack semiconductor device according to an embodiment;
FIG. 7A is a diagram for describing a multi-stack semiconductor device 10b according to another embodiment;
FIG. 7B is a diagram for describing a multi-stack semiconductor device 10b according to another embodiment;
FIG. 7C is a schematic diagram briefly illustrating a partial configuration of a cross-section taken along line C1-C1' of FIGS. 7A and 7B;
FIG. 8 is a front-side plan view of a multi-stack semiconductor device according to another embodiment;
FIG. 9 is a front-side plan view of a multi-stack semiconductor device as a comparative example with respect to a multi-stack semiconductor device according to embodiments; and
FIG. 10 is a back-side plan view of a multi-stack semiconductor device as a comparative example with respect to a multi-stack semiconductor device according to embodiments.

### DETAILED DESCRIPTION

It will be understood that when an element or layer is referred to as being "over," "above," "on," "below," "under," "beneath," another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," another element or layer, there are no intervening elements or layers present.

It will be understood that when an element or layer is referred to as being "connected to", or "coupled to" another element or layer, it may be directly on, connected to, or coupled to the other element or layer, or one or more intervening elements or layers may be present. In contrast, when an element is referred to as being "directly coupled," "directly connected," or "directly responsive" to, or "directly on," another element, there are no intervening elements present.

In addition, "electrical connection" conceptually includes a physical connection and a physical disconnection.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Hereinafter, embodiments will be described in detail with reference to the accompanying drawings. Herein, like reference numerals will denote like elements, and redundant descriptions thereof will be omitted for conciseness.

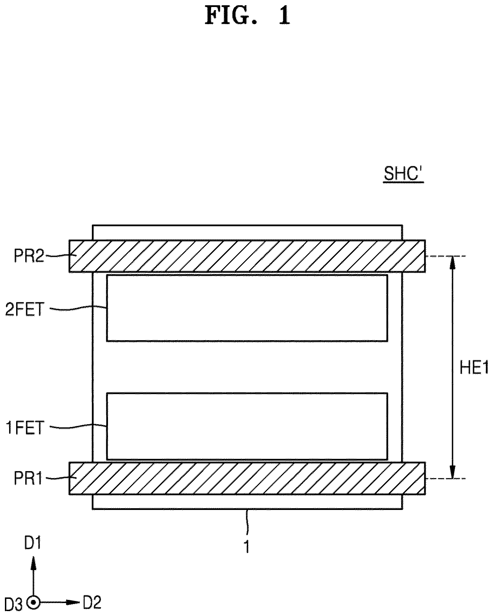

FIG. 1 is a conceptual diagram for describing a logic cell of a semiconductor device as a comparative example.

Referring to FIG. 1, a single height cell SHC' may be provided. Particularly, a first power rail PR1 and a second power rail PR2 may be provided over a substrate 1. First power VDD, for example, positive-potential power, may be applied to one of the first power rail PR1 and the second power rail PR2. Second power VSS, for example, negative-potential or ground-potential power, may be applied to the other one of the first power rail PR1 and the second power rail PR2. For example, the first power VDD may be applied to the first power rail PR1, and the second power VSS may be applied to the second power rail PR2.

The single height cell SHC' may be defined between the first power rail PR1 and the second power rail PR2. The single height cell SHC' may include a first field effect transistor (FET) 1FET and a second FET 2FET. One of the first FET 1FET and the second FET 2FET may be a p-channel metal oxide semiconductor field effect transistor (PMOSFET) region, and the other one of the first FET 1FET and the second FET 2FET may be an n-channel metal oxide semiconductor field effect transistor (NMOSFET) region. For example, the first FET 1FET may be a PMOSFET region, and the second FET 2FET may be an NMOSFET region. In other words, the single height cell SHC' may have a complementary metal oxide semiconductor (CMOS) structure provided between the first power rail PR1 and the second power rail PR2.

The semiconductor device according to the comparative example may be a two-dimensional device, and transistors of a front end of line (FEOL) layer may be two-dimensionally arranged. For example, PMOSFETs of the first FET 1FET and NMOSFETs of the second FET 2FET may be formed apart from each other in a first direction D1.

The length of the single height cell SHC' according to the comparative example in the first direction D1 may be defined as a first height HE1. The first height HE1 may be substantially equal to the distance (e.g., pitch) between the first power rail PR1 and the second power rail PR2.

The single height cell SHC' may constitute one logic cell. Herein, the logic cell may refer to a logic element (e.g., AND, OR, XOR, XNOR, or inverter) that performs a particular function. That is, the logic cell may include transistors constituting a logic element and lines connecting the transistors to each other.

Because the single height cell SHC' according to the comparative example includes a two-dimensional device, the first FET 1FET and the second FET 2FET may not overlap each other and may be arranged apart from each other in the first direction D1. Thus, the first height HE1 of the single height cell SHC' should be defined to cover both the first FET 1FET and the second FET 2FET spaced apart from each other in the first direction D1. As a result, the first height HE1 of the single height cell SHC' according to the comparative example may have no choice but to be relatively great. In other words, the area of the single height cell SHC' according to the comparative example may be relatively great.

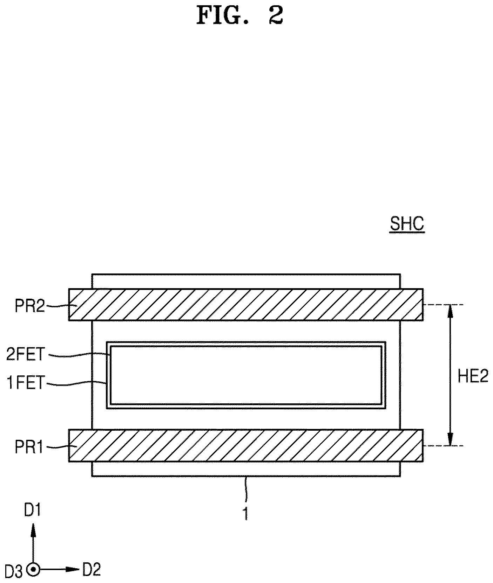

FIG. 2 is a conceptual diagram for describing a logic cell of a semiconductor device according to embodiments. FIG. 2 illustrates a logic cell of a multi-stack semiconductor device according to an embodiment.

Referring to FIG. 2, a single height cell SHC including a multi-stack semiconductor device (e.g., a stacked transistor) may be provided. Particularly, a first power rail PR1 and a second power rail PR2 may be provided over a substrate 1. The single height cell SHC may be defined between the first power rail PR1 and the second power rail PR2.

The single height cell SHC may include a first FET 1FET and a second FET 2FET. One of the first FET 1FET and the second FET 2FET may be a PMOSFET region, and the other one of the first FET 1FET and the second FET 2FET may be an NMOSFET region.

The semiconductor device according to the present embodiments may be a multi-stack semiconductor device, in which transistors of an FEOL layer may be vertically stacked. The first FET 1FET may be provided as a bottom tier over the substrate 110, and the second FET 2FET may be stacked as a top tier over the first FET 1FET. For example, PMOSFETs of the first FET 1FET may be provided over the substrate 1, and NMOSFETs of the second FET 2FET may be stacked over the PMOSFETs. The first FET 1FET and the second FET 2FET may be spaced apart from each other in a vertical direction, that is, in a third direction D3.

The length of the single height cell SHC according to the present embodiments in the first direction D1 may be defined as a second height HE2. Because the single height cell SHC according to the present embodiments includes a multi-stack semiconductor device, that is, a stacked transistor, the first FET 1FET and the second FET 2FET may overlap each other. As a result, the second height HE2 of the single height cell SHC according to the present embodiments may be less than the first height HE1 of the single height cell SHC' of FIG. 1 described above. In other words, the area of the single height cell SHC according to the present embodiments may be relatively small. The multi-stack semiconductor device according to the present embodiments may improve the device integration level by reducing the area of the logic cell.

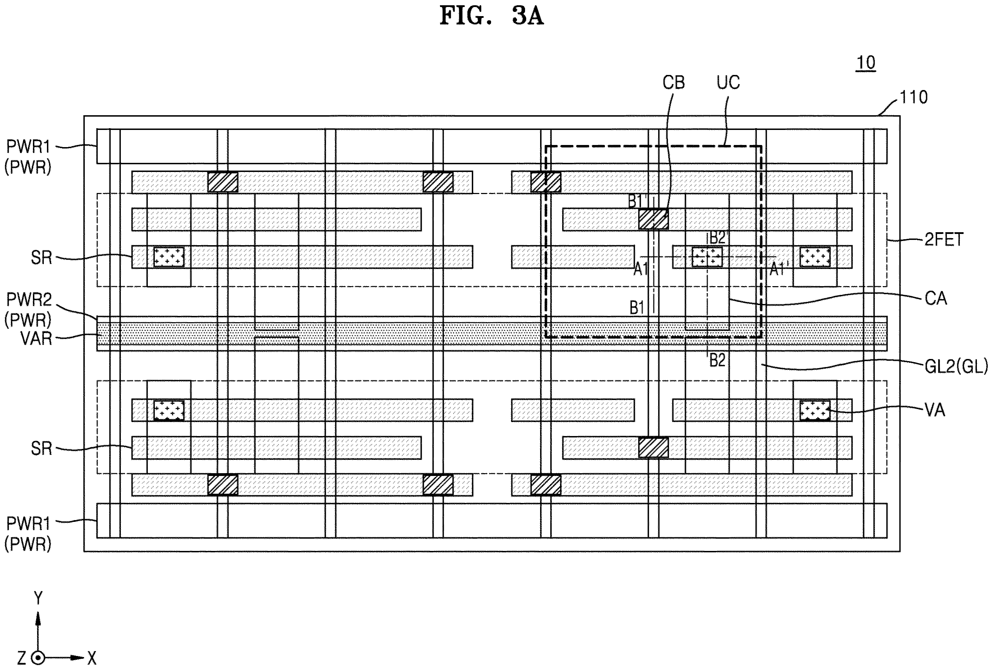

FIG. 3A is a front-side plan view of a multi-stack semiconductor device 10 according to an embodiment.

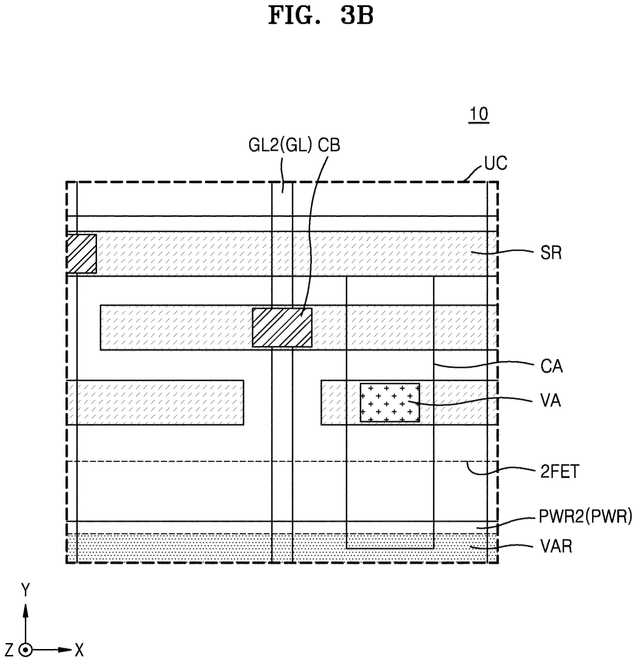

FIG. 3B is a plan view illustrating a partial configuration of a multi-stack semiconductor device 10 according to an embodiment.

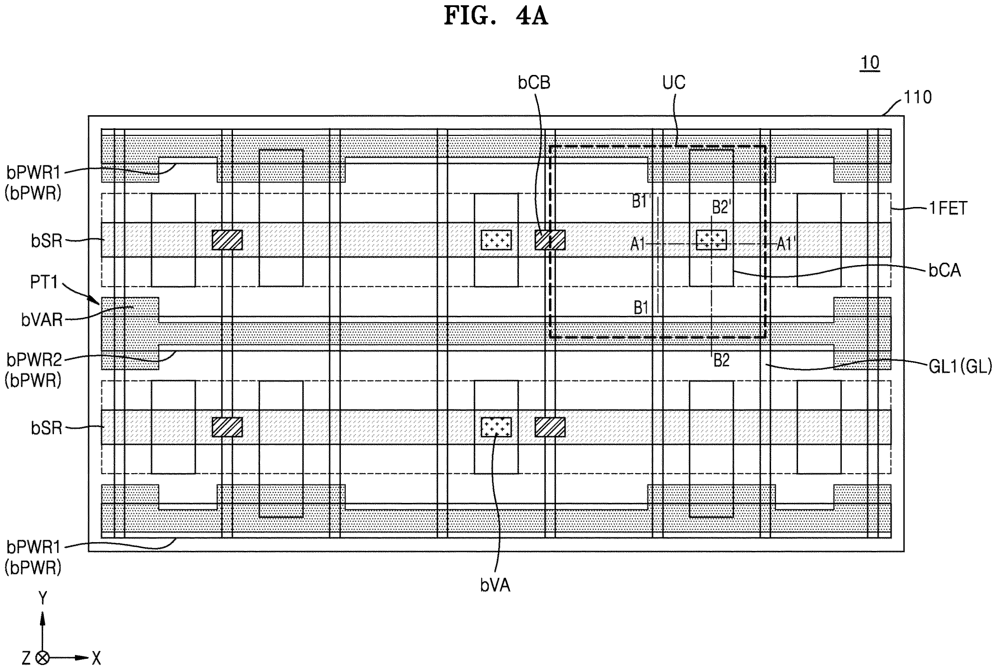

FIG. 4A is a back-side plan view of a multi-stack semiconductor device 10 according to an embodiment.

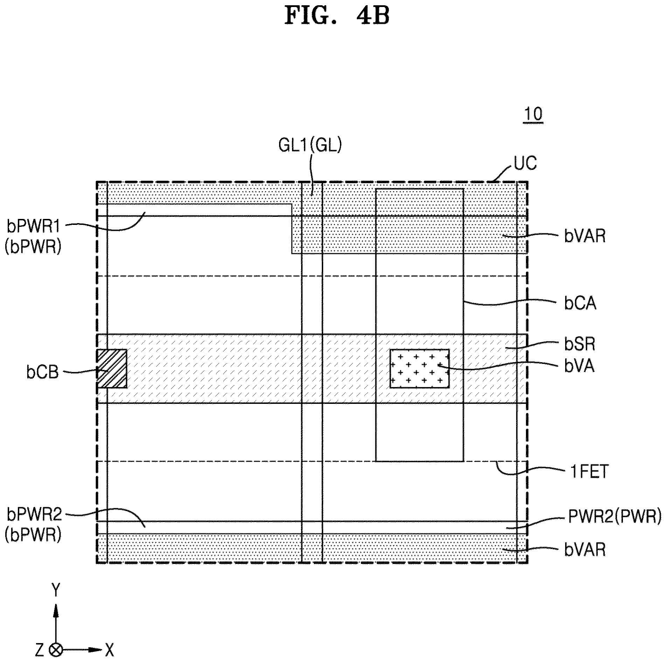

FIG. 4B is a plan view illustrating a partial configuration of a multi-stack semiconductor device 10 according to an embodiment.

Referring to FIGS. 3A, 3B, 4A, and 4B, the multi-stack semiconductor device 10 according to an embodiment may include a substrate 110 including a front surface and a rear surface facing the front surface. The front surface of the substrate 110 may correspond to an active surface of the substrate 110, and the rear surface of the substrate 110 may correspond to an inactive surface of the substrate 110. In the present embodiments, the front surface of the substrate 110 may be an upper surface of the substrate 110, and the rear surface of the substrate 110 may be a lower surface of the substrate 110.

As illustrated in FIGS. 3A and 3B, the multi-stack semiconductor device 10 according to an embodiment may include a second FET 2FET, a source/drain contact CA, a source/drain via VA, a source/drain via rail VAR, a gate line GL, a gate contact CB, a front-side signal rail SR, and a power rail PWR arranged over the front surface of the substrate 110.

As illustrated in FIGS. 4A and 4B, the multi-stack semiconductor device 10 according to an embodiment may include a first FET 1FET, a back-side source/drain contact bCA, a back-side source/drain via bVA, a back-side source/drain via rail bVAR, a gate line GL, a back-side signal rail bSR, and a back-side power rail bPWR arranged over the rear surface of the substrate 110.

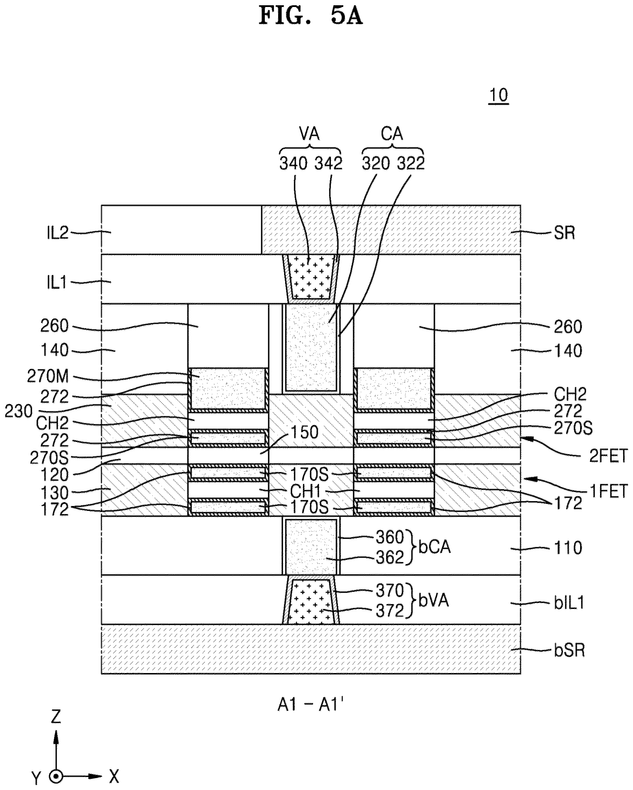

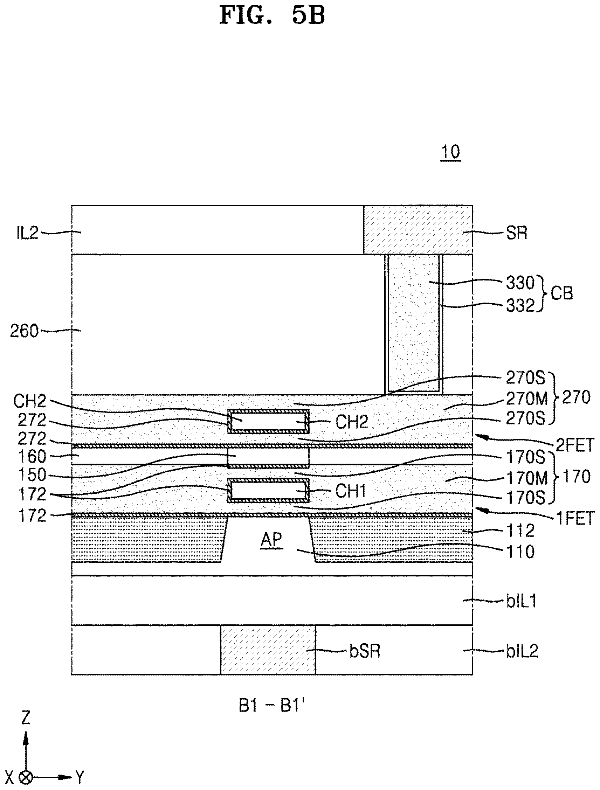

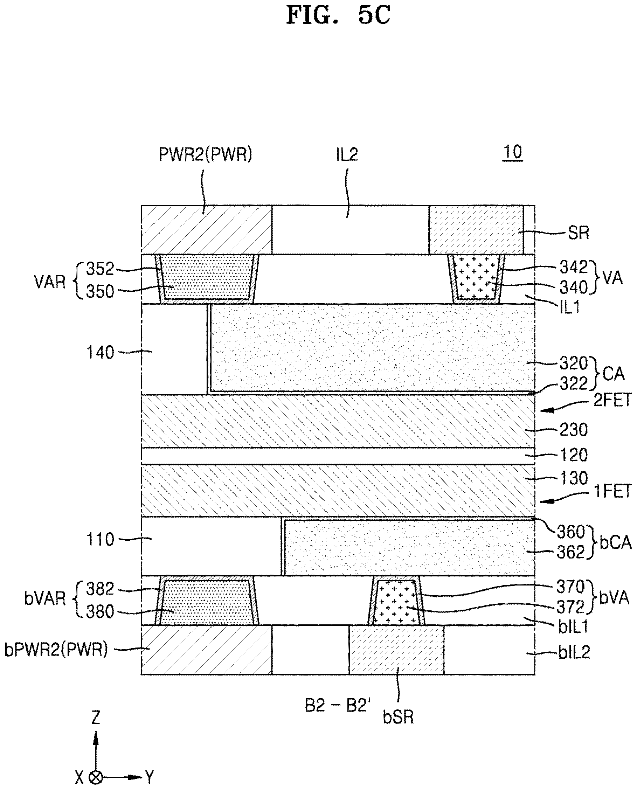

In the multi-stack semiconductor device 10, the back-side signal rail bSR and the back-side power rail bPWR may be located in a first layer, the back-side source/drain via bVA and the back-side source/drain via rail bVAR may be located in a second layer, the first FET 1FET may be located in a third layer, the second FET 2FET may be located in a fourth layer, the source/drain contact CA may be located in a fifth layer, the source/drain via VA, the gate contact CB, and the source/drain via rail VAR may be located in a sixth layer, and the front-side signal rail SR and the power rail PWR may be located in a seventh layer. The first to seventh layers described above may be located at different vertical levels and may be located at higher vertical levels as it goes from the first layer toward the seventh layer. For example, the second layer may be located at a higher vertical level than the first layer, and the third layer may be located at a higher vertical level than the second layer. As used herein, the term "vertical level" may mean the distance from the front surface of the substrate 110 in the vertical direction (Z direction or -Z direction). A particular vertical position relationship of the components included in the multi-stack semiconductor device 10 will be described below with reference to FIGS. 5A, 5B, and 5C.

One of the first FET 1FET and the second FET 2FET may be a PMOSFET region, and the other one of the first FET 1FET and the second FET 2FET may be an NMOSFET region. The first FET 1FET may be provided in a bottom tier of an FEOL layer, and the second FET 2FET may be provided in a top tier of the FEOL layer. The first FET 1FET and the second FET 2FET may be stacked in the vertical direction (Z direction) to constitute a three-dimensional (3D) stacked transistor. In an embodiment, the first FET 1FET may be a PMOSFET region, and the second FET 2FET may be an NMOSFET region. In another embodiment, the first FET 1FET may be an NMOSFET region, and the second FET 2FET may be a PMOSFET region. In the plan view, the stacked first FET 1FET and second FET 2FET may be located between a pair of power rails PWR spaced apart from each other and a pair of back-side power rails bPWR spaced apart from each other.

For example, the first FET 1FET and the second FET 2FET may each include a fin field effect transistor (finFET) and a gate-all-around (GAA) transistor such as a nanosheet transistor. A detailed configuration of the first FET 1FET and the second FET 2FET will be described below with reference to FIGS. 5A, 5B, and 5C.

Referring to FIGS. 3A and 3B, a plurality of power rails PWR and a plurality of front-side signal rails SR may be provided. The plurality of power rails PWR and the plurality of front-side signal rails SR may extend in a first horizontal direction (X direction). Among the plurality of power rails PWR, a first power rail PWR1 may be configured to provide first power VDD, for example, positive-potential power, to the second FET 2FET. Among the plurality of power rails PWR, a second power rail PWR2 may be configured to provide second power VSS, for example, negative-potential or ground-potential power, to the second FET 2FET. The plurality of power rails PWR may be electrically connected to the second FET 2FET through the source/drain via rail VAR and the source/drain contact CA. The plurality of front-side signal rails SR may be arranged between the first power rail PWR1 and the second power rail PWR2. Each of the plurality of front-side signal rails SR may be electrically connected to a second source/drain region (see 230 in FIG. 5A) of the second FET 2FET through the source/drain via VA and the source/drain contact CA. Each of the plurality of front-side signal rails SR may be electrically connected to a second gate line GL2 of the second FET 2FET by the gate contact CB. Signals may be input/output to/from the second FET 2FET through the plurality of front-side signal rails SR respectively.

In some embodiments, a wiring layer may be configured in a multi-layer structure over the front surface of the substrate 110, and a plurality of power rails PWR and a plurality of front-side signal rails SR may be included in the lowermost wiring layer among the wiring layers of the multi-layer structure. Although not illustrated, the multi-stack semiconductor device 10 may include a plurality of power rails PWR, a plurality of front-side signal rails SR, and at least one or more wiring layers having different vertical levels.

Referring to FIGS. 4A and 4B, a plurality of back-side power rails bPWR and a plurality of back-side signal rails bSR may be provided. The plurality of back-side power rails bPWR and the plurality of back-side signal rails bSR may extend in the first horizontal direction (X direction). Among the plurality of back-side power rails bPWR, a first back-side power rail bPWR1 may be configured to provide second power VSS, for example, negative-potential or ground-potential power, to the first FET 1FET. Among the plurality of back-side power rails PWR, a second back-side power rail bPWR2 may be configured to provide first power VDD, for example, positive-potential power, to the first FET 1FET. Each of the plurality of back-side signal rails bSR may be arranged between the first back-side power rail bPWR1 and the second back-side power rail bPWR2 and may be spaced apart from the first back-side power rail bPWR1 and the second back-side power rail bPWR2 in a second horizontal direction (Y direction). Each of the plurality of back-side signal rails bSR may be electrically connected to a first source/drain region (see 130 of FIG. 5A) of the first FET 1FET through the back-side source/drain contact bCA. Each of the plurality of back-side signal rails bSR may be electrically connected to a first gate line GL1 of the first FET 1FET by the back-side gate contact bCB. Signals may be input/output to/from the first FET 1FET through the plurality of back-side signal rails bSR respectively.

As illustrated in FIGS. 3B and 4B, in the multi-stack semiconductor device 10, a region between one first power rail PWR1 and one second power rail PWR2 and a region between two second gate lines GL2 adjacent to each other with respect to one center second gate line GL2 may constitute one unit cell UC. In other words, a region between one first back-side power rail bPWR1 and one second back-side power rail bPWR2 and a region between two first gate lines GL1 adjacent to each other with respect to one center first gate line GL1 may constitute one unit cell UC.

One unit cell UC including one first back-side power rail bPWR1, one second back-side power rail bPWR2, and components arranged therebetween may correspond to a standard cell and may be used as a basic layout when designing an integrated circuit. For example, the standard cell may include a basic cell such as AND, OR, NOR, inverter, NAND, or NOR, a complex cell such as OR/AND/INVERTER (OAI) and AND/OR/INVERTER (AOI), and a storage element such as a simple master-slave flip-flop and a latch.

A standard cell method may be a method of preparing logic circuit blocks with various functions, that is, cells, in advance and arbitrarily combining the cells to design a dedicated large-scale integrated circuit (LSI) customized to the needs of the customer or user. The cells may be designed and verified in advance and registered in a computer in advance, and logic design, arrangement, wiring, or the like may be performed by combining the registered cells by using computer aided design (CAD).

Particularly, in the case of designing/manufacturing a large-scale integrated circuit, when standardized logic circuit blocks of a certain scale, that is, standard cells, are already stored in a library, the entire circuit may be designed by taking out standard cells suitable for the current design purpose from the library, arranging the standard cells as a plurality of cells over a chip, and performing optimal wiring with the shortest wiring length in a wiring space between the cells. As the number of types of cells stored in the library increases, the flexibility in design may increase and the possibility of optimal chip design may increase accordingly.

In some embodiments, the unit cell UC of the multi-stack semiconductor device 10 may include an inverter. The inverter may be implemented by connecting a PMOSFET and an NMOSFET in series. In other embodiments, in the multi-stack semiconductor device 10, the unit cell UC is not limited to an inverter and may include other logic elements. For example, a PMOSFET and an NMOSFET may be connected in parallel.

As illustrated in FIGS. 3A, 3B, 4A, and 4B, a plurality of gate lines GL may be arranged apart from each other in the first horizontal direction (X direction), and each of the plurality of gate lines GL may extend long in the second horizontal direction (Y direction).

As illustrated in FIGS. 3A and 3B, the multi-stack semiconductor device 10 may include a plurality of source/drain contacts CA over the front surface of the substrate 110 and a plurality of source/drain vias VA and a source/drain via rail VAR electrically connected to the plurality of source/drain contacts CA. Also, the multi-stack semiconductor device 10 may include a gate contact CB electrically connected to the plurality of gate lines GL, for example, to the second gate line GL2.

The plurality of source/drain vias VA and the source/drain via rail VAR may overlap at least a portion of the source/drain contact CA in the vertical direction (Z direction). In some embodiments, the horizontal width of the plurality of source/drain vias VA in the first horizontal direction (X direction) and/or the second horizontal direction (Y direction) may be equal to or less than the horizontal width of the source/drain contact CA in the first horizontal direction (X direction) and/or the second horizontal direction (Y direction). In some embodiments, the source/drain via rail VAR may extend long in the first horizontal direction (X direction) to overlap at least a portion of the power rail PWR in the vertical direction (Z direction).

As illustrated in FIGS. 4A and 4B, the multi-stack semiconductor device 10 may include a plurality of back-side source/drain contacts bCA over the rear surface of the substrate 110 and a plurality of back-side source/drain vias bVA and a back-side source/drain via rail bVAR electrically connected to the plurality of back-side source/drain contacts bCA. Also, the multi-stack semiconductor device 10 may include a back-side gate contact bCB electrically connected to the plurality of gate lines GL, for example, to the first gate line GL1.

The plurality of back-side source/drain vias bVA and the back-side source/drain via rail bVAR may overlap at least a portion of the back-side source/drain contact bCA in the vertical direction (Z direction). In some embodiments, the horizontal width of the plurality of back-side source/drain vias bVA in the first horizontal direction (X direction) and/or the second horizontal direction (Y direction) may be equal to or less than the horizontal width of the back-side source/drain contact bCA in the first horizontal direction (X direction) and/or the second horizontal direction (Y direction). In some embodiments, the back-side source/drain via rail bVAR may extend long in the first horizontal direction (X direction) to overlap at least a portion of the back-side power rail bPWR in the vertical direction (Z direction).

In some embodiments, the back-side source/drain via rail bVAR may include a first protrusion portion PT1 for expanding the area overlapping the back-side source/drain contact bCA in the vertical direction (Z direction). The first protrusion portion PT1 may be a portion of the back-side source/drain via rail bVAR that protrudes in the second horizontal direction (Y direction) from a first rail portion extending long in the first horizontal direction (X direction). The first protrusion portion PT1 may include a plurality of first protrusion portions PT1, and the plurality of first protrusion portions PT1 may be arranged apart from each other along both sides of the first rail portion of the back-side source/drain via rail bVAR.

The plurality of source/drain contacts CA, the plurality of source/drain vias VA, the source/drain via rail VAR, the gate contact CB, the back-side source/drain contact bCA, the plurality of back-side source/drain vias bVA, and the back-side source/drain via rail bVAR will be described below in detail with reference to FIGS. 5A, 5B, and 5C.

FIG. 5A is a diagram illustrating a partial configuration of a cross-section taken along line A1-A1' of FIGS. 3A and 4A.

FIG. 5B is a diagram illustrating a partial configuration of a cross-section taken along line B1-B1' of FIGS. 3A and 4A.

FIG. 5C is a diagram illustrating a partial configuration of a cross-section taken along line B2-B2' of FIGS. 3A and 4A.

Referring to FIGS. 5A, 5B, and 5C, the multi-stack semiconductor device 10 may include a substrate 110. The substrate 110 may include an active region AP that protrudes from the front surface of the substrate 110 in the vertical direction (Z direction). The substrate 110 may include a semiconductor such as Si or Ge or a compound semiconductor such as SiGe, SiC, GaAs, InAs, InGaAs, or InP. The substrate 110 may include a conductive region, for example, a well doped with dopants or a structure doped with dopants. A device isolation layer 112 may be located on the side surface of the active region AP in the second horizontal direction (Y direction). The device isolation layer 112 may cover the side surface of the active region AP while filling a plurality of trench regions formed at the side surface of the active region AP in the second horizontal direction (Y direction). The device isolation layer 112 may include a silicon oxide layer; however, the inventive concept is not limited thereto.

The first FET 1FET may include a first channel layer CH1, a first source/drain region 130, and a first gate line 170. The second FET 2FET may include a second channel layer CH2, a second source/drain region 230, and a second gate line 270. The second FET 2FET may be stacked over and spaced apart from the first FET 1FET in the vertical direction (Z direction).

The first channel layer CH1 may be arranged over and spaced apart from the active region AP in the vertical direction (Z direction). The second channel layer CH2 may be arranged apart from the first channel layer CH1 in the vertical direction (Z direction) with a sub gate insulating layer 150 therebetween. According to embodiments, the first channel layer CH1 and the second channel layer CH2 may include a nanosheet or a nanosheet stack including a plurality of nanosheets; however, the inventive concept is not limited thereto. According to embodiments, the first channel layer CH1 and the second channel layer CH2 may include a plurality of first channel layers CH1 and a plurality of second channel layers CH2, respectively. The plurality of first channel layers CH1 and the plurality of second channel layers CH2 may be stacked and spaced apart from each other in the vertical direction (Z direction). In this case, each first channel layer CH1 and each second channel layer CH2 may function as a channel region. The number of first channel layers CH1 that may be included in the first FET 1FET and the number of second channel layers CH2 that may be included in the second FET 2FET are not particularly limited.

According to embodiments, the first channel layer CH1 and the second channel layer CH2 may include a Si layer, a SiGe layer, or any combination thereof. According to embodiments, the first channel layer CH1 and the second channel layer CH2 may have a multi-bridge channel (MBC) structure and four sides thereof may be surrounded by the first gate line 170 and the second gate line 270 respectively. Here, the four sides may include both sides in the second horizontal direction (Y direction) and both sides in the vertical direction (Z direction).

As illustrated in FIGS. 5A and 5B, the first gate line 170 may be arranged over the active region AP and the device isolation layer 112. The first gate line 170 may extend in the second horizontal direction (Y direction) and may cover the first channel layer CH1 arranged over the active region AP. The first gate line 170 may cover the upper and lower surfaces of the first channel layer CH1 and both side surfaces of the first channel layer CH1 in the second horizontal direction (Y direction). The first source/drain region 130 may be formed on both side surfaces of the first channel layer CH1 in the first horizontal direction (X direction). Each of the first gate lines 170 may include a metal, a metal nitride, a metal carbide, or any combination thereof. The metal may be selected from among Ti, W, Ru, Nb, Mo, Hf, Ni, Co, Pt, Yb, Tb, Dy, Er, and Pd. The metal nitride may be selected from among TiN and TaN. The metal carbide may be TiAlC. However, the component materials of the first gate line 170 are not limited thereto.

The first gate line 170 may include a first sub gate 170S covering the upper and lower portions of the first channel CH1 in the vertical direction (Z direction) and a first main gate 170M extending in the second horizontal direction (Y direction) over the device isolation layer 112. The thickness of the first sub gate 170S in the vertical direction (Z direction) may be less than the thickness of the first main gate 170M in the vertical direction (Z direction).

A first gate dielectric layer 172 may be arranged between the first channel layer CH1 and the first gate line 170. The first gate dielectric layer 172 may cover the active region AP and the upper surface of the device isolation layer 112 and may cover the first channel layer CH1. The first gate dielectric layer 172 may include a stack structure of an interface dielectric layer and a high-k dielectric layer. The interface dielectric layer may include a low dielectric material layer with a dielectric constant of about 9 or less, for example, a silicon oxide layer, a silicon oxynitride layer, or any combination thereof. In some embodiments, the interface dielectric layer may be omitted. The high-k dielectric layer may include a material having a higher dielectric constant than a silicon oxide layer. For example, the high-k dielectric layer may have a dielectric constant of about 10 to about 25. The high-k dielectric layer may include a hafnium oxide; however, the inventive concept is not limited thereto.

The first sub gate 170S may be spaced apart from the first source/drain region 130 in the first horizontal direction (X direction) with the first gate dielectric layer 172 therebetween. The first sub gate 170S may be spaced apart from the substrate 110 in the vertical direction (Z direction) with the first gate dielectric layer 172 therebetween. The first sub gate 170S may be spaced apart from the sub gate insulating layer 150 in the vertical direction (Z direction) with the first gate dielectric layer 172 therebetween. The first gate dielectric layer 172 may cover the lower surface of the first main gate 170M and both side surfaces of the first main gate 170M in the first horizontal direction (X direction).

As illustrated in FIG. 5A, the first source/drain region 130 may be formed on both sides of the first channel layer CH1 in the first horizontal direction (X direction). The first source/drain region 130 may include an epitaxially grown semiconductor layer. In some embodiments, the first source/drain region 130 may include an epitaxially grown Si layer, an epitaxially grown SiC layer, or a plurality of epitaxially grown SiGe layers. When the first source/drain region 130 constitutes an NMOS transistor, the first source/drain region 130 may include a Si layer doped with an n-type dopant or a SiC layer doped with an n-type dopant. The n-type dopant may be selected from among phosphorus (P), arsenic (As), and antimony (Sb). When the first source/drain region 130 constitutes a PMOS transistor, the first source/drain region 130 may include a SiGe layer doped with a p-type dopant. The p-type dopant may be selected from among boron (B) and gallium (Ga).

As illustrated in FIG. 5A, a first insulating layer 120 may be arranged between the first source/drain region 130 and the second source/drain region 230. The first insulating layer 120 may cover the upper surface of the first source/drain region 130 and may cover the lower surface of the second source/drain region 230. The first source/drain region 130 and the second source/drain region 230 overlapping each other in the vertical direction (Z direction) may be spaced apart from each other in the vertical direction (Z direction) by the first insulating layer 120. Also, the first FET 1FET and the second FET 2FET overlapping each other in the vertical direction (Z direction) may be spaced apart from each other in the vertical direction (Z direction) by the first insulating layer 120.

The first insulating layer 120 may include a silicon oxide, SiOC, SiOCN, SiCN, SiBN, SiON, SiBCN, SiOF, SiOCH, or any combination thereof. The first insulating layer 120 may include a single layer including one material layer selected from among the materials listed above or may include multiple layers including a plurality of material layers selected from among the materials listed above. The terms SiOC, SiOCN, SiCN, SiBN, SiON, SiBCN, SiOF, and SiOCH used herein refer to materials including elements included in the respective terms but do not refer to chemical formulas representing stoichiometric relationships.

Also, a second insulating layer 140 may cover the upper surface of the second source/drain region 230. Because the second insulating layer 140 may include substantially the same material as the first insulating layer 120, redundant descriptions thereof will be omitted for conciseness.

As illustrated in FIG. 5B, the portion of the first gate line 170 that does not overlap the active region AP in the vertical direction (Z direction) may be understood as the first main gate 170M. Also, the portion of the second gate line 270 that does not overlap the active region AP in the vertical direction (Z direction) may be understood as a second main gate 270M.

As illustrated in FIG. 5B, a main gate insulating layer 160 may be formed to cover the upper surface of the first main gate 170M of the first gate line 170. The main gate insulating layer 160 may extend in the second horizontal direction (Y direction). The sub gate insulating layer 150 may be formed to cover the upper surface of the first sub gate 170S of the first gate line 170, and the first gate line 170 may be isolated from the second gate line 270 through the main gate insulating layer 160 and the sub gate insulating layer 150. The first gate line 170 may be spaced apart from the second gate line 270 in the vertical direction (Z direction) with the main gate insulating layer 160 and the sub gate insulating layer 150 therebetween.

As illustrated in FIGS. 5A and 5B, the second gate line 270 may be arranged over the sub gate insulating layer 150 and the main gate insulating layer 160. Particularly, the second gate line 270 may be formed over the sub gate insulating layer 150 and the main gate insulating layer 160 formed over the first FET 1FET. The second gate line 270 may extend in the second horizontal direction (Y direction) and may cover the second channel layer CH2 formed over the sub gate insulating layer 150. Because the second gate line 270 is substantially the same as or similar to the first gate line 170, redundant descriptions thereof will be omitted for conciseness.

A second gate dielectric layer 272 may be arranged between the second channel layer CH2 and the second gate line 270. The second gate dielectric layer 272 may cover the upper surface of each of the sub gate insulating layer 150 and the main gate insulating layer 160 and may cover the second channel layer CH2. A second sub gate 270S may be spaced apart from the sub gate insulating layer 150 in the vertical direction (Z direction) with the second gate dielectric layer 272 therebetween. The second gate dielectric layer 272 may cover the lower surface of the second main gate 270M.

As illustrated in FIG. 5A, the second source/drain region 230 may be formed on both sides of the second channel layer CH2 in the first horizontal direction (X direction). The second source/drain area 230 may be spaced apart from the second sub gate 270S in the first horizontal direction (X direction) with the second gate dielectric layer 272 therebetween.

As illustrated in FIG. 5A, a third insulating layer 260 may be formed to cover the upper surface of the second main gate 270M of the second gate line 270. The third insulating layer 260 may extend in the second horizontal direction (Y direction).

As illustrated in FIGS. 5A and 5C, the source/drain contact CA may be electrically connected to the second source/drain region 230 of the second FET 2FET by passing through the second insulating layer 140 in the vertical direction (Z direction). The source/drain contact CA may include a contact plug 320 and a conductive barrier layer 322 surrounding the lower surface and sidewall of the contact plug 320. The contact plug 320 may include molybdenum (Mo), tungsten (W), cobalt (Co), ruthenium (Ru), manganese (Mn), titanium (Ti), tantalum (Ta), aluminum (Al), copper (Cu), or any combination thereof or any alloy thereof; however, the inventive concept is not limited thereto. The conductive barrier layer 322 may include metal or conductive metal nitride, for example, Ti, Ta, W, titanium nitride (TiN), tantalum nitride (TaN), tungsten nitride (WN), tungsten carbon nitride (WCN), titanium silicon nitride (TiSiN), tantalum silicon nitride (TaSiN), tungsten silicon nitride (WSiN), or any combination thereof; however, the inventive concept is not limited thereto. However, in other embodiments, the source/drain contact CA may include only the contact plug 320. In other words, the conductive barrier layer 322 may be omitted from the source/drain contact CA.

As illustrated in FIGS. 5A and 5C, the upper surface of each of the source/drain contact CA, the second insulating layer 140, and the third insulating layer 260 may be covered by a first upper insulating layer IL 1. The first upper insulating layer IL1 may include an etch stop layer and an interlayer insulating layer sequentially stacked over the upper surface of each of the source/drain contact CA, the second insulating layer 140, and the third insulating layer 260. The etch stop layer may include silicon carbide (SiC), SiN, nitrogen-doped silicon carbide (SiC:N), SiOC, AlN, AlON, AlO, AlOC, or any combination thereof. The interlayer insulating layer may include an oxide layer, a nitride layer, an ultra low-k (ULK) layer with an ultra low dielectric constant K of about 2.2 to about 2.4, or any combination thereof. For example, the interlayer insulating layer 184 may include a tetraethylorthosilicate (TEOS) layer, a high density plasma (HDP) oxide layer, a boro-phospho-silicate glass (BPSG) layer, a flowable chemical vapor deposition (FCVD) oxide layer, a SiON layer, a SiN layer, a SiOC layer, a SiCOH layer, or any combination thereof; however, the inventive concept is not limited thereto.

As illustrated in FIGS. 5A and 5C, the source/drain via VA and the source/drain via rail VAR may be arranged over the source/drain contact CA. The source/drain via VA and the source/drain via rail VAR may contact the source/drain contact CA by passing through the first upper insulating layer II,1. The second source/drain region 230 of the second FET 2FET may be electrically connected to the source/drain via VA and the source/drain via rail VAR through the source/drain contact CA. The lower surface of each of the source/drain via VA and the source/drain via rail VAR may contact the upper surface of the source/drain contact CA. Similarly to the source/drain contact CA, the source/drain via VA may include a contact plug 340 and a conductive barrier layer 342 covering the sidewall and lower surface of the contact plug 340, and the component materials of the contact plug 340 and the conductive barrier layer 342 may be similar to those in the source/drain contact CA described above.

Referring to FIG. 3A, while the source/drain via VA has a pillar shape, the source/drain via rail VAR may have a rail shape extending in the first horizontal direction (X direction) along the power rail PWR.

As illustrated in FIG. 5C, the horizontal width of the source/drain via rail VAR in the second horizontal direction (Y direction) may be equal to or less than the horizontal width of the power rail PWR in the second horizontal direction (Y direction). The source/drain via rail VAR may be arranged on the same vertical level as the source/drain via VA. In other words, the source/drain via rail VAR may be arranged between the source/drain contact CA and the power rail PWR. Through the source/drain via rail VAR, the source/drain contact CA may be electrically connected to the power rail PWR. Similarly to the source/drain via VA, the source/drain via rail VAR may include a conductive layer 350 and a conductive barrier layer 352 surrounding the sidewall and lower surface of the conductive layer 350. The conductive layer 350 may include molybdenum (Mo), copper (Cu), tungsten (W), cobalt (Co), ruthenium (Ru), manganese (Mn), titanium (Ti), tantalum (Ta), aluminum (Al), or any combination thereof or any alloy thereof; however, the inventive concept is not limited thereto. For example, the conductive layer 352 may include Ti, Ta, W, TiN, TaN, WN, WCN, TiSiN, TaSiN, WSiN, or any combination thereof; however, the inventive concept is not limited thereto.

In some embodiments, the source/drain via rail VAR may be formed simultaneously with the source/drain via VA. In other embodiments, the source/drain via rail VAR and the source/drain via VA may be sequentially formed. For example, the source/drain via rail VAR may be first formed and then the source/drain via VA may be formed, or the source/drain via VA may be first formed and then the source/drain via rail VAR may be formed. The source/drain via rail VAR may be formed through a similar process to the source/drain via VA. For example, the source/drain via rail VAR may be formed by arranging a mask including a hole for forming the source/drain contact CA and a trench for forming the source/drain via rail VAR and then conformally depositing the conductive barrier layer 352 constituting the source/drain via rail VAR in the trench and depositing the conductive layer 350 in the trench with the conductive barrier layer 352 formed therein.

As illustrated in FIG. 5B, the gate contact CB may be electrically connected to the second gate line 270 of the second FET 2FET by passing through the third insulating layer 260 in the vertical direction (Z direction). The gate contact CB may include a contact plug 330 and a conductive barrier layer 332 surrounding the lower surface and sidewall of the contact plug 330. The component material of the contact plug 330 and the component material of the conductive barrier layer 332 may be similar to those of the contact plug 320 and the conductive barrier layer 322 constituting the source/drain contact CA described above.

In some embodiments, the upper surface of the source/drain via VA, the upper surface of the source/drain via rail VAR, the upper surface of the gate contact CB, and the upper surface of the first upper insulating layer IL1 may be coplanar with each other.

As illustrated in FIGS. 5A, 5B, and 5C, each of the upper surface of the source/drain via VA, the upper surface of the source/drain via rail VAR, the upper surface of the gate contact CB, and the upper surface of the first upper insulating layer IL1 may be covered by a second upper insulating layer IL2. The component material of the second upper insulating layer IL2 may be substantially similar to that of the first upper insulating layer IL1 described above.

A plurality of front-side signal rails SR and a power rail PWR may pass through the second upper insulating layer IL2. Each of the plurality of front-side signal rails SR may be electrically connected to the source/drain via VA or the gate contact CB arranged thereunder. The power rail PWR may be electrically connected to the source/drain via rail VAR arranged thereunder. Each of the plurality of front-side signal rails SR and the power rail PWR may include molybdenum (Mo), copper (Cu), tungsten (W), cobalt (Co), ruthenium (Ru), manganese (Mn), titanium (Ti), tantalum (Ta), aluminum (Al), or any combination thereof or any alloy thereof; however, the inventive concept is not limited thereto.

As illustrated in FIGS. 5A, 5B, and 5C, the back-side source/drain contact bCA may be connected to the first source/drain region 130 of the first FET 1FET by passing through the substrate 110. The back-side source/drain contact bCA may include a contact plug 360 and a conductive barrier layer 362 surrounding the upper surface and sidewall of the contact plug 360. The component materials of the contact plug 360 and the conductive barrier layer 362 may be substantially similar to those of the contact plug 320 and the conductive barrier layer 322 constituting the source/drain contact CA described above.

Each of the lower surface of the back-side source/drain contact bCA and the lower surface of the substrate 110 may be covered by a first lower insulating layer bIL1. The component material of the first lower insulating layer bIL1 may be substantially similar to that of the first upper insulating layer IL1 described above.

The back-side source/drain via bVA and the back-side source/drain via rail bVAR may be arranged under the back-side source/drain contact bCA. The back-side source/drain via bVA and the back-side source/drain via rail bVAR may contact the back-side source/drain contact bCA by passing through the first lower insulating layer bIL1. The first source/drain region 130 of the first FET 1FET may be electrically connected to the back-side source/drain via bVA and the back-side source/drain via rail bVAR through the back-side source/drain contact bCA. The upper surface of each of the back-side source/drain via bVA and the back-side source/drain via rail bVAR may contact the lower surface of the back-side source/drain contact bCA. Similarly to the source/drain contact CA, the back-side source/drain via bVA may include a contact plug 370 and a conductive barrier layer 372 covering the sidewall and lower surface of the contact plug 370, and the component materials of the contact plug 370 and the conductive barrier layer 372 may be similar to those in the source/drain contact CA described above.

As illustrated in FIG. 4A, while the back-side source/drain via bVA has a pillar shape, the back-side source/drain via rail bVAR may have a rail shape extending in the first horizontal direction (X direction) along the back-side power rail bPWR.

As illustrated in FIG. 5C, the horizontal width of the back-side source/drain via rail bVAR in the second horizontal direction (Y direction) may be equal to or less than the horizontal width of the back-side power rail bPWR in the second horizontal direction (Y direction). The back-side source/drain via rail bVAR may be arranged on the same vertical level as the back-side source/drain via bVA. In other words, the back-side source/drain via rail bVAR may be arranged between the back-side source/drain contact bCA and the back-side power rail bPWR. Through the back-side source/drain via rail bVAR, the back-side source/drain contact CA may be electrically connected to the back-side power rail bPWR. Similarly to the source/drain via rail VAR, the back-side source/drain via rail bVAR may include a conductive layer 380 and a conductive barrier layer 382 surrounding the sidewall and lower surface of the conductive layer 380.

In some embodiments, the back-side source/drain via rail bVAR may be formed simultaneously with the back-side source/drain via bVA. In other embodiments, the back-side source/drain via rail bVAR and the back-side source/drain via bVA may be sequentially formed. The formation process of the back-side source/drain via rail bVAR may be similar to the formation process of the source/drain via rail VAR.

In some embodiments, the lower surface of the back-side source/drain via bVA, the lower surface of the back-side source/drain via rail bVAR, and the lower surface of the first lower insulating layer bIL1 may be coplanar with each other.

As illustrated in FIGS. 5A, 5B, and 5C, each of the lower surface of the back-side source/drain via bVA, the lower surface of the back-side source/drain via rail bVAR, and the lower surface of the first lower insulating layer bIL1 may be covered by a second lower insulating layer bIL2. The component material of the second lower insulating layer bIL2 may be substantially similar to that of the first lower insulating layer bIL1 described above.

The back-side signal rail bSR and the back-side power rail bPWR may pass through the second lower insulating layer bIL2 in the vertical direction (Z direction). Each of the back-side signal rails bSR may be electrically connected to the back-side source/drain via bVA arranged thereover. The back-side power rail bPWR may be electrically connected to the back-side source/drain via rail bVAR arranged thereover. The back-side signal rail bSR and the back-side power rail bPWR may include similar materials as the front-side signal rail SR and the power rail PWR respectively.

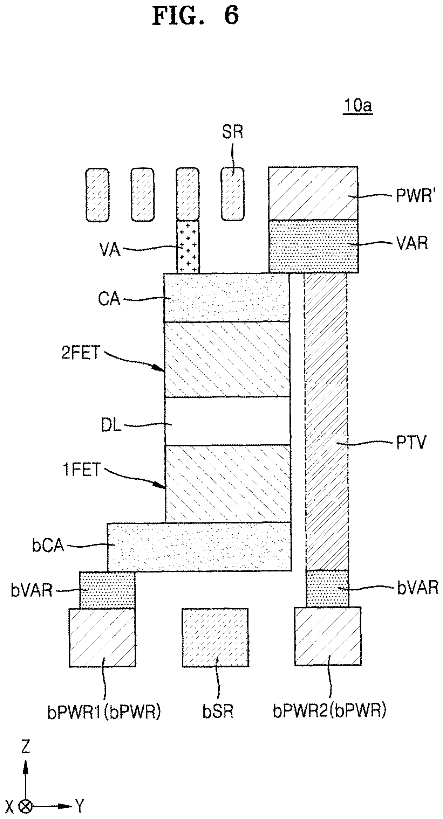

FIG. 6 is a schematic diagram briefly illustrating a multi-stack semiconductor device 10a according to an embodiment. Because the multi-stack semiconductor device 10a is substantially similar to the multi-stack semiconductor device 10 described with reference to FIGS. 3A, 3B, 4A, 4B, 5A, 5B, and 5C, differences therebetween will be mainly described below.

Referring to FIG. 6, the first FET 1FET and the second FET 2FET may be isolated by an insulating layer DL, and a source/drain contact CA, a source/drain via VA, a source/drain via rail VAR, a power rail PWR', and a front-side signal rail SR may be arranged over the second FET 2FET. A back-side source/drain contact bCA, a back-side source/drain via rail bVAR, a back-side power rail bPWR, and a back-side signal rail bSR may be arranged under the first FET 1FET.

The source/drain via rail VAR may be arranged between a power tap via PTV and the power rail PWR', and the back-side source/drain via rail bVAR may be arranged between the power tap via PTV and the back-side power rail bPWR.

As illustrated in FIG. 6, the multi-stack semiconductor device 10a according to an embodiment may include a power tap cell (PTC). The power rail PWR' may be electrically connected to the back-side power rail bPWR through the power tap via PTV arranged in the power tap cell. In other words, instead of receiving power separately from the back-side power rail bPWR like the power rail PWR of the multi-stack semiconductor device 10, the power rail PWR' of the multi-stack semiconductor device 10a may receive power from the back-side power rail bPWR. For example, the first back-side power rail bPWR1 may be configured to supply first power VDD to the first FET 1FET, and the second back-side power rail bPWR2 may be configured to supply second power VSS different from the first power VDD to the second FET 2FET through the power tap via PTV and the source/drain via rail VAR.

In some embodiments, one power tap cell including the power tap via PTV may be arranged for every tens to hundreds of contacted poly pitches (CPPs) in the X direction. For example, one power tap cell (PTC) may be arranged for every about 60 CPPs. Herein, the CPP may refer to the pitch of a gate in the first horizontal direction (X direction).

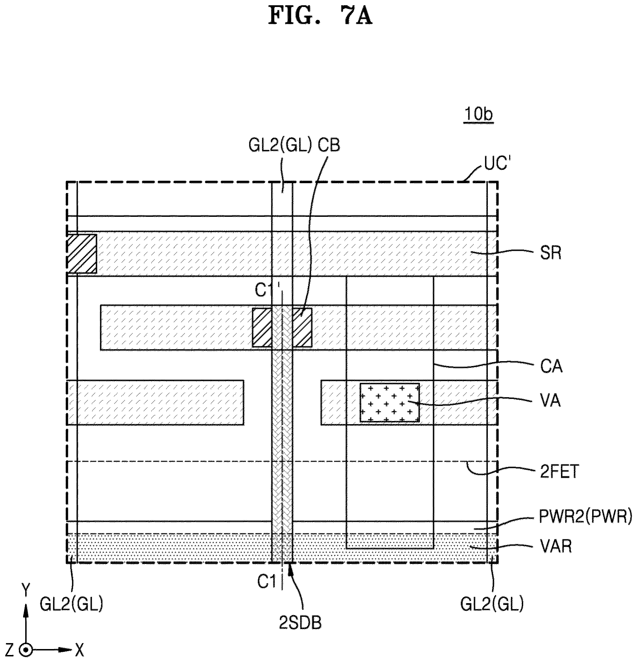

FIG. 7A is a diagram for describing a multi-stack semiconductor device 10b according to another embodiment.

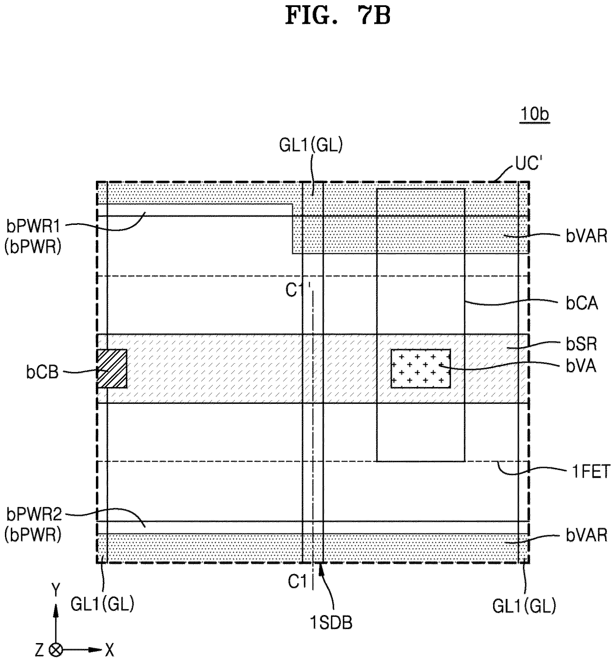

FIG. 7B is a diagram for describing a multi-stack semiconductor device 10b according to another embodiment.

FIGS. 7A and 7B each illustrate a region corresponding to region "UC" in FIGS. 3A and 4A.

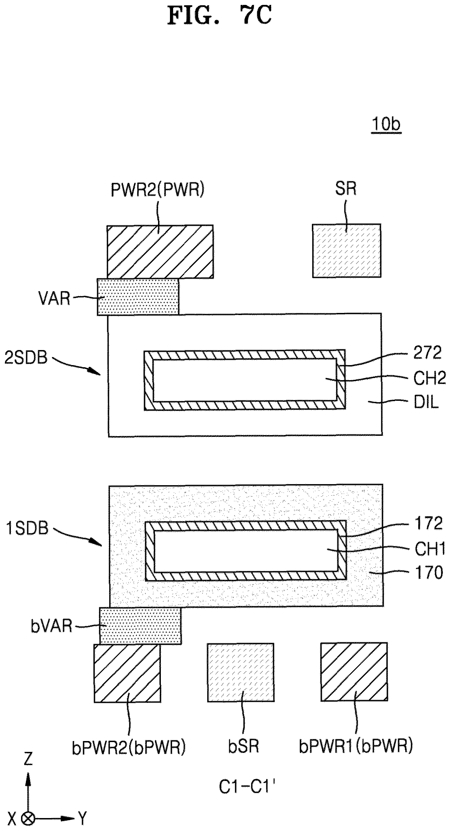

FIG. 7C is a schematic diagram briefly illustrating a partial configuration of a cross-section taken along line C1-C1' of FIGS. 7A and 7B.

Because the multi-stack semiconductor device 10b is substantially similar to the multi-stack semiconductor device 10 described with reference to FIGS. 3A, 3B, 4A, 4B, 5A, 5B, and 5C, differences therebetween will be mainly described below.

Referring to FIGS. 7A, 7B, and 7C, the multi-stack semiconductor device 10b may include a diffusion break for providing electrical device isolation, for example, a first diffusion break 1SDB including an electrical single diffusion break (eSDB), and a diffusion break for providing dielectric device isolation, for example, a second diffusion break 2SDB including a single diffusion break (SDB). The diffusion break may refer to a break in a diffusion region extending from a first edge of a cell to a second edge facing the first edge of the cell.

Herein, "dummy gates" may represent a shape drawn at the edge of a standard cell to isolate the standard cell from an adjacent standard cell. The dummy gates may be for insulating purpose only and therefore may not perform any logic function. In a particular semiconductor process, the dummy gates may provide electrical device isolation or dielectric device isolation.

Herein, a diffusion break that is a structure for isolating a plurality of transistors from each other or a diffusion break formed across one gate line among the diffusion breaks will be referred to as a "single diffusion break (SDB)". In the case of a SDB, it may be formed in a space from which any one gate line has been removed and may have a horizontal width substantially equal to the horizontal width of one gate line in the first horizontal direction (X direction). Among the SDBs, a structure using a transistor in an off state may be referred to as an eSDB.

Moreover, a "double diffusion break (DDB)" may be an active isolation structure different from the SDB and may be formed across two gate lines. For example, the DDB may be a structure formed by removing at least a portion of two adjacent gate lines and the above active region therebetween and may have a pitch between gate lines in the first horizontal direction (X direction), for example, a width corresponding to the CPP, and in the DDB, two adjacent gate lines may correspond to a dummy gate line. Thus, considering the aspect of the area of the cell, two cells including the DDB may be larger by 1 CPP in the X direction than two cells including the SDB.

In some embodiments, the first gate line 170 of the multi-stack semiconductor device 10b may be electrically connected to the first back-side power rail bPWR1 or the second back-side power rail bPWR2 through the back-side source/drain via rail bVAR, and the first back-side power rail bPWR1 or the second back-side power rail bPWR2 may not be electrically connected to a power supply and thus may not receive power from the first back-side power rail bPWR1 or the second back-side power rail bPWR2 and thus may be in an off state. In FIG. 7C, a structure is described in which the first gate line 170 of the multi-stack semiconductor device 10b may be electrically connected to the second back-side power rail bPWR2 through the back-side source/drain via rail bVAR. Accordingly, a first diffusion break 1SDB may be formed.

In some embodiments, in the multi-stack semiconductor device 10 described above, a first diffusion break 1SDB may be arranged between two adjacent first FETs 1FET, and two adjacent first source/drain regions 130 (see FIG. 5A) may be isolated from each other by the first diffusion break 1SDB. For example, the first diffusion break 1SDB may be arranged inside the cell boundary of a unit cell UC'. However, the inventive concept is not limited thereto, and the first diffusion break 1SDB may be arranged over the cell boundary of the unit cell UC'. Because the first diffusion break 1SDB uses electrical device isolation using the back-side source/drain via rail bVAR instead of using dielectric device isolation, the process thereof may be easier than the case of using dielectric device isolation.

The multi-stack semiconductor device 10b may include a diffusion blocking insulating layer DIL. The diffusion blocking insulating layer DIL may include, for example, at least one of silicon nitride (SiN) and a combination of SiN and an oxide material including silicon oxide (SiO), silicon dioxide (SiO₂), or tonen silazene (TOSZ); however, the inventive concept is not limited thereto. In an embodiment, the second diffusion break 2SDB for isolating two adjacent NMOSFETs may include a material such as TOSZ, and the case of including such a material may be advantageous for controlling the tensile stress of the NMOSFET. The second diffusion break 2SDB for isolating two adj acent PMOSFETs may include at least one of silicon nitride (SiN) and a combination of SiN and an oxide material including silicon oxide (SiO), silicon dioxide (SiO₂), or tonen silazene (TOSZ) and may be advantageous for controlling the compressive stress of the PMOSFET.

In some embodiments, in the multi-stack semiconductor device 10 described above, a second diffusion break 2SDB may be arranged between two adjacent second FETs 2FET, and two adjacent second source/drain regions 230 (see FIG. 5A) may be isolated from each other by the second diffusion break 2SDB. For example, the second diffusion break 2SDB may be formed to pass through the space between the two adjacent second source/drain regions 230 of FIG. 5A in which the second gate line 270, the second gate dielectric layer 272, and the second channel layer CH2 are arranged. For example, the second diffusion break 2SDB may be arranged inside the cell boundary of the unit cell UC'. However, the inventive concept is not limited thereto, and the second diffusion break 2SDB may be arranged over the cell boundary of the unit cell UC'.

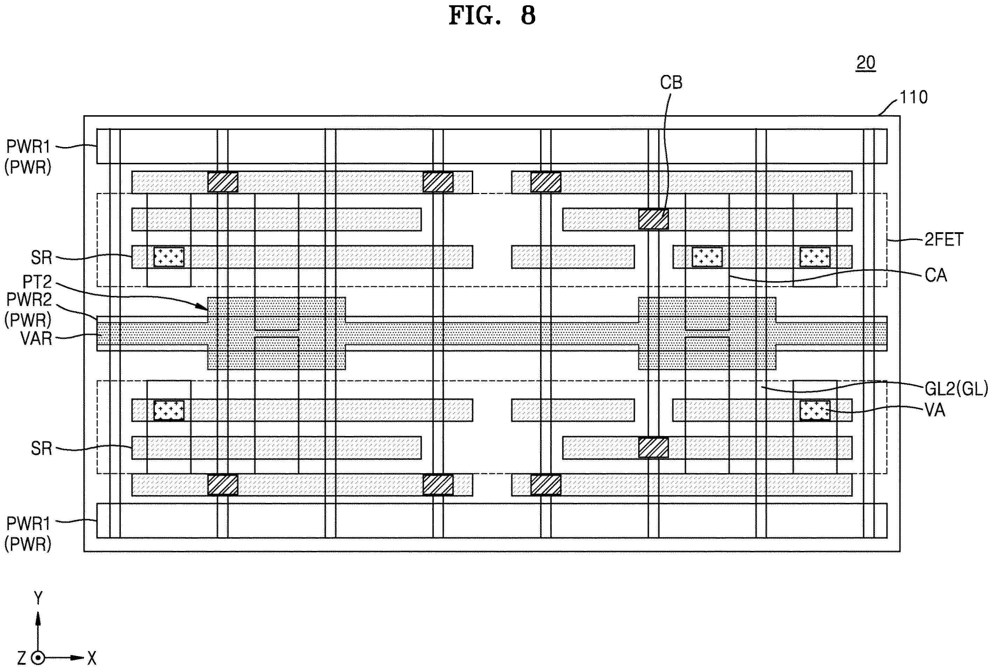

FIG. 8 is a front-side plan view of a multi-stack semiconductor device 20 according to another embodiment. Because the multi-stack semiconductor device 20 is substantially similar to the multi-stack semiconductor device 10 described with reference to FIGS. 3A, 3B, 4A, 4B, 5A, 5B, and 5C, differences therebetween will be mainly described below.

The multi-stack semiconductor device 20 may include a second FET 2FET, a source/drain contact CA, a source/drain via VA, a source/drain via rail VAR, a gate line GL, a gate contact CB, a front-side signal rail SR, and a power rail PWR arranged over the front surface of the substrate 110. Although not illustrated, as illustrated in FIGS. 4A and 4B, the multi-stack semiconductor device 20 may include a first FET 1FET, a back-side source/drain contact bCA, a back-side source/drain via bVA, a back-side source/drain via rail bVAR, a gate line GL, a back-side signal rail bSR, and a back-side power rail bPWR arranged over the rear surface of the substrate 110.

In some embodiments, the source/drain via rail VAR may include a second protrusion portion PT2 for expanding the area overlapping the source/drain contact CA in the vertical direction (Z direction). The second protrusion portion PT2 may be a portion of the source/drain via rail VAR that protrudes in the second horizontal direction (Y direction) from a second rail portion extending long in the first horizontal direction (X direction). The second protrusion portion PT2 may include a plurality of second protrusion portions PT2, and the plurality of second protrusion portions PT2 may be arranged apart from each other along both sides of the second rail portion of the source/drain via rail VAR.

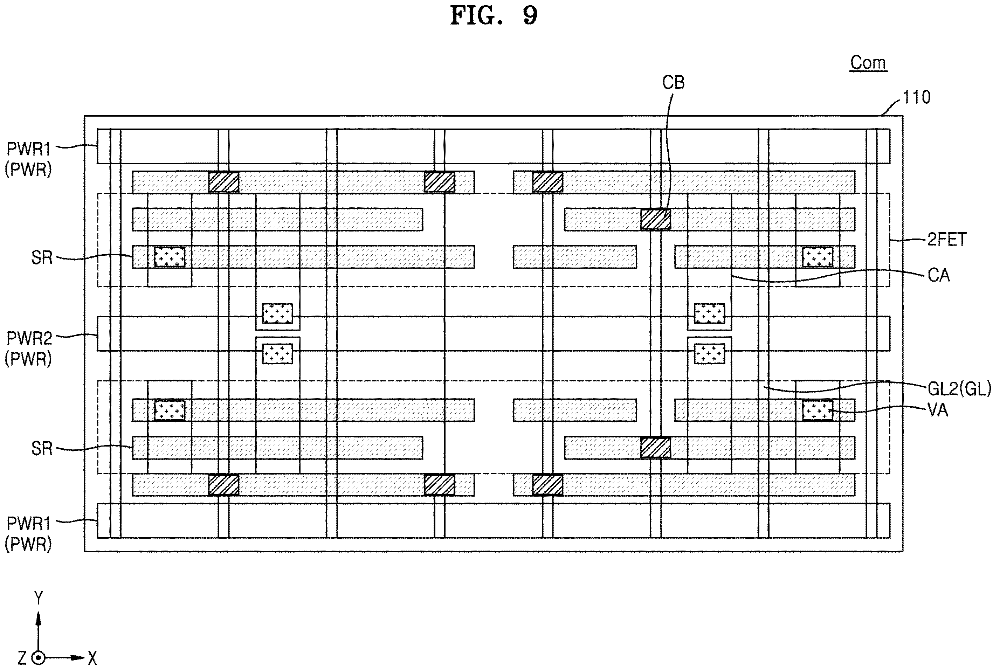

FIG. 9 is a front-side plan view of a multi-stack semiconductor device Com as a comparative example with respect to a multi-stack semiconductor device according to embodiments.

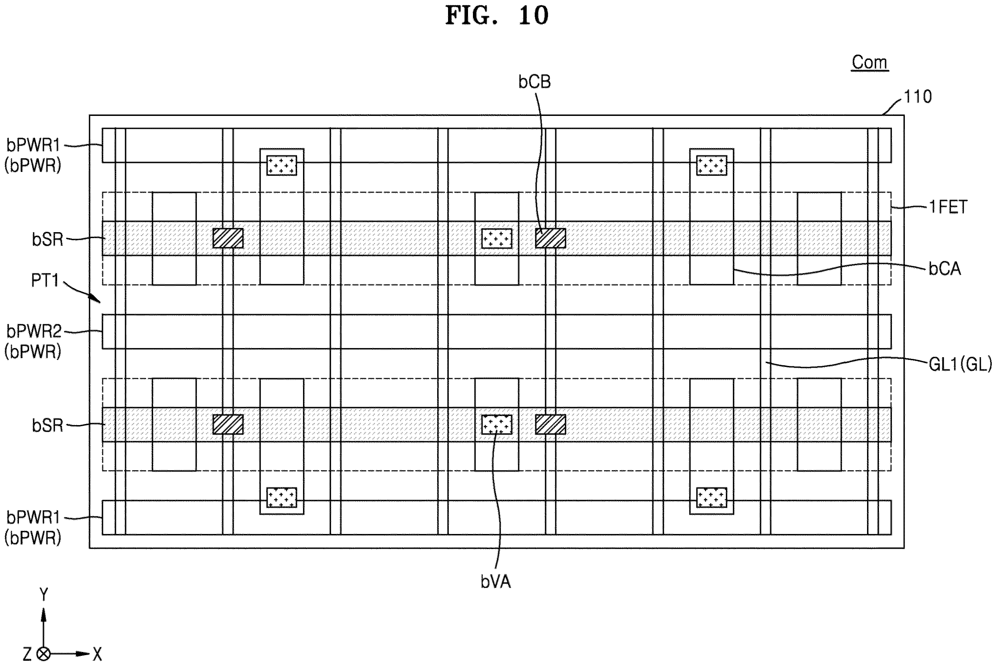

FIG. 10 is a back-side plan view of a multi-stack semiconductor device Com as a comparative example with respect to a multi-stack semiconductor device according to embodiments.

Referring to FIGS. 9 and 10, the multi-stack semiconductor device Com as a comparative example may not include the source/drain via rail VAR overlapping the power rail PWR in the vertical direction (Z direction) and the back-side source/drain via rail bVAR overlapping the back-side power rail bPWR in the vertical direction (Z direction) and may further include a source/drain via VA overlapping the power rail PWR in the vertical direction (Z direction) and a back-side source/drain via bVA overlapping the back-side power rail bPWR in the vertical direction (Z direction).

The contact area between the power rail PWR and the source/drain via VA and between the back-side power rail bPWR and the back-side source/drain via bVA in the multi-stack semiconductor devices 10 and 20 according to embodiments may be greater than the contact area between the power rail PWR and the source/drain via rail VAR and between the back-side power rail bPWR and the back-side source/drain via rail bVAR in the multi-stack semiconductor device Com.

Thus, the source/drain via rail VAR and the power rail PWR of the multi-stack semiconductor devices 10 and 20 according to embodiments may have lower resistance than the source/drain via VA and the power rail PWR of the multi-stack semiconductor device Com as a comparative example. Also, the back-side source/drain via rail bVAR and the back-side power rail bPWR of the multi-stack semiconductor devices 10 and 20 may have lower resistance than the back-side source/drain via bVA and the back-side power rail bPWR of the multi-stack semiconductor device Com as a comparative example. Furthermore, because the contact area between the source/drain via rail VAR and the source/drain contact CA of the multi-stack semiconductor device 20 is greater than that of the multi-stack semiconductor device 10, the source/drain via rail VAR and the power rail PWR of the multi-stack semiconductor device 20 may have lower resistance than those of the multi-stack semiconductor device 10.

While inventive concepts have been particularly shown and described with reference to embodiments thereof, it will be understood that various changes in form and details may be made therein without departing from the scope of the following claims.

## Claims

1. A multi-stack semiconductor device comprising:
a back-side power rail (bPWR) extending in a first horizontal direction (X);
a first field effect transistor, FET, (1FET) at a level over the back-side power rail (bPWR);
a second FET (2FET) over the first FET (1FET);
a power rail (PWR) over the second FET (2FET) and extending in the first horizontal direction (X);
a back-side source/drain via rail (bVAR) between the back-side power rail (bPWR) and the first FET (1FET), the back-side source/drain via rail (bVAR) electrically connecting the back-side power rail (bPWR) to the first FET (1FET); and
a source/drain via rail (VAR) between the power rail (PWR) and the second FET (2FET), the source/drain via rail (VAR) electrically connecting the power rail (PWR) to the second FET (2FET), wherein
the back-side source/drain via rail (bVAR) and the source/drain via rail (VAR) extend in the first horizontal direction (X),
the back-side source/drain via rail (bVAR) at least partially overlaps the back-side power rail (bPWR) in a vertical direction (Z), and
the source/drain via rail (VAR) at least partially overlaps the power rail (PWR) in the vertical direction (Z).

2. The multi-stack semiconductor device of claim 1, wherein
the first FET (1FET) comprises a first channel (CH1), a first gate line (170) covering the first channel (CH1) and extending in a second horizontal direction (Y) intersecting the first horizontal direction (X), and a first source/drain region (130) on both sides of the first channel (CH1) in the first horizontal direction (X), and
the second FET (2FET) comprises a second channel (CH2), a second gate line (270) covering the second channel (CH2) and extending in the second horizontal direction (Y), and a second source/drain region (230) on both sides of the second channel (CH2) in the first horizontal direction (X).

3. The multi-stack semiconductor device of claim 2, further comprising:
an electrical single diffusion break (1SDB) over the back-side source/drain via rail (bVAR).

4. The multi-stack semiconductor device of claim 2 or 3, further comprising:
a single diffusion break (2SDB) under the source/drain via rail (VAR).

5. The multi-stack semiconductor device of any one of claims 1 to 4, wherein
the source/drain via rail (VAR) comprises a conductive layer (350) and a conductive barrier layer (352), and
the conductive barrier layer (352) covers a side surface of the conductive layer (350) and a lower surface of the conductive layer (350).

6. The multi-stack semiconductor device of claim 5, wherein
the conductive layer (350) comprises molybdenum, Mo, copper, Cu, tungsten, W, cobalt, Co, ruthenium, Ru, manganese, Mn, titanium, Ti, tantalum, Ta, or aluminum, Al, or any combination thereof, or any alloy thereof, and
the conductive barrier layer comprises Ti, Ta, W, titanium nitride, TiN, tantalum nitride, TaN, tungsten nitride, WN, tungsten carbon nitride, WCN, titanium silicon nitride, TiSiN, tantalum silicon nitride, TaSiN, or tungsten silicon nitride, WSiN, or any combination thereof.

7. The multi-stack semiconductor device of any one of claims 1 to 6, wherein the back-side source/drain via rail (bVAR) comprises:
a first rail portion extending in the first horizontal direction (X); and a first protrusion portion (PT1) protruding from a side surface of the first rail portion.

8. The multi-stack semiconductor device of any one of claims 1 to 7, wherein the source/drain via rail (VAR) comprises:
a second rail portion extending in the first horizontal direction (X); and
a second protrusion portion (PT2) protruding from a side surface of the second rail portion.

9. The multi-stack semiconductor device of any one of claims 1 to 8, further comprising:
a back-side source/drain contact (bCA) between the back-side source/drain via rail (bVAR) and the first FET (1FET); and
a source/drain contact (CA) between the source/drain via rail (VAR) and the second FET (2FET), wherein
at least a portion of the back-side source/drain contact (bCA) overlaps the back-side source/drain via rail (bVAR) in the vertical direction (Z), and
at least a portion of the source/drain contact (CA) overlaps the source/drain via rail (VAR) in the vertical direction (Z).

10. The multi-stack semiconductor device of any one of claims 1 to 9, further comprising:
a back-side source/drain via (bVA) at a same level as the back-side source/drain via rail (bVAR) in the vertical direction (Z); and
a source/drain via (VA) at a same level as the source/drain via rail (VAR) in the vertical direction (Z), wherein
the back-side source/drain via (bVA) and the source/drain via (VA) have a pillar shape.

11. The multi-stack semiconductor device of claim 10, further comprising:
a back-side signal rail (bSR) neighboring the back-side power rail (bPWR) in a second horizontal direction (Y) intersecting the first horizontal direction (X), the back-side signal rail extending in the first horizontal direction; and
a front-side signal rail (SR) neighboring the power rail (PWR) in the second horizontal direction (Y) and extending in the first horizontal direction (X),
wherein the back-side signal rail (bSR) is electrically connected to the back-side source/drain via (bVA), and
the front-side signal rail (SR)is electrically connected to the source/drain via (VA).

12. The multi-stack semiconductor device of claim 1, wherein
the back-side power rail (bPWR) is configured to supply a first power to the back-side source/drain via rail (bVAR), and
the power rail (PWR) is configured to supply a second power to the source/drain via rail (VAR).

13. A multi-stack semiconductor device comprising:
a first back-side power rail (bPWR1) and a second back-side power rail (bPWR2) extending in a first horizontal direction (X);
a back-side signal rail (bSR) between the first back-side power rail (bPWR1) and the second back-side power rail (bPWR2), the back-side signal rail (bSR) being spaced apart from the first back-side power rail (bPWR1) in a second horizontal direction (Y), the second horizontal direction intersecting the first horizontal direction (X), and the back-side signal rail (bSR) extending in the first horizontal direction;
a back-side source/drain via rail (bVAR) connected to the first back-side power rail (bPWR1);
a first field effect transistor (FET) (1FET) at a level over the back-side source/drain via rail (bVAR); and
a second FET (2FET) over the first FET (1FET), wherein
the first back-side power rail (bPWR1) is configured to supply first power, and
the second back-side power rail (bPWR2) is configured to supply second power different from the first power.

14. The multi-stack semiconductor device of claim 13, further comprising:
a source/drain via rail (VAR) over the second FET (2FET); and
a power tap via (PTV) electrically connecting the source/drain via rail (VAR) and the second back-side power rail (bPWR2) to each other.

15. The multi-stack semiconductor device of claim 13 or 14, further comprising:
a source/drain via rail (VAR) over the second FET (2FET); and
a power rail (PWR) over the source/drain via rail (VAR), wherein
a horizontal width of the source/drain via rail (VAR) in the second horizontal direction (Y) is less than or equal to a horizontal width of the power rail (PWR).
